Europäisches Patentamt

European Patent Office

Office européen des brevets

(19)

(11) Numéro de publication: **0 112 202**
**B1**

(12) **FASCICULE DE BREVET EUROPEEN**

(45) Date de publication du fascicule du brevet: **09.03.88**

(51) Int. Cl.⁴: **H 04 N 1/18, H 01 L 27/14**

(21) Numéro de dépôt: **83402189.1**

(22) Date de dépôt: **10.11.83**

(54) **Dispositif de lecture de document point par point utilisant une matrice d'éléments photodétecteurs.**

(30) Priorité: **17.11.82 FR 8219229**

(43) Date de publication de la demande:
**27.06.84 Bulletin 84/26**

(45) Mention de la délivrance du brevet:
**09.03.88 Bulletin 88/10**

(84) Etats contractants désignés:
**DE FR GB**

(56) Documents cités:
**EP-A-0 075 858**
**US-A-4 064 521**
**US-A-4 233 506**
**US-A-4 271 435**
**PATENTS ABSTRACTS OF JAPAN, vol. 6, no. 6, 14 janvier 1982, page 128 E 89**
**PATENTS ABSTRACTS OF JAPAN, vol. 6, no. 144, 3 aou7t 1982, page 60 E 122**
**PATENTS ABSTRACTS OF JAPAN, vol. 6, no. 77, 14 mai 1982, page 100 E 106**
**PATENTS ABSTRACTS OF JAPAN, vol. 6, no. 47, 26 mars 1982, page 145 E 99**

(73) Titulaire: **COMMISSARIAT A L'ENERGIE ATOMIQUE**
**31/33, rue de la Fédération**
**F-75015 Paris (FR)**

(72) Inventeur: **Chenevas-Paule, Andre**
**42, rue de Stalingrad**
**F-38100 Grenoble (FR)**
Inventeur: **Cuchet, Robert**
**Monestier du Percy**
**F-38930 Clelles (FR)**

(74) Mandataire: **Mongrédien, André et al**
**c/o BREVATOME 25, rue de Ponthieu**
**F-75008 Paris (FR)**

Courier Press, Leamington Spa, England.

## Description

La présente invention a pour objet un dispositif de lecture de document point par point utilisant une matrice d'éléments photodétecteurs. Elle trouve notamment son application dans l'analyse des documents pour la télécopie.

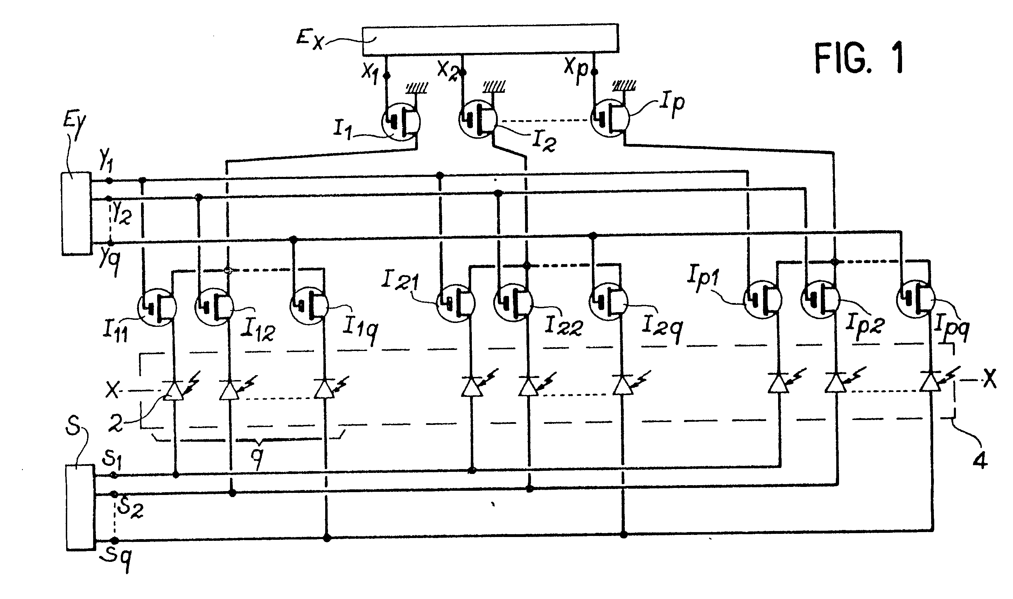

Selon l'art connu, présenté en particulier dans ACTA Electronica, vol. 21, no. 1, 1978, pp 55—79, les moyens d'analyse des appareils de télécopie comprennent une tête de lecture constituée d'une barrette d'éléments photodétecteurs. De manière générale, pour lire un document de format standard A4, la barrette comprend 1 728 éléments photodétecteurs alignés permettant d'analyser une ligne du document. Pour réduire, le nombre de connexions entre ces éléments photodétecteurs et les circuits électroniques de traitement, on réalise un adressage multiplexé de ces éléments photodétecteurs. Ces circuits d'adressage sont réalisés sur la barrette même. La figure 1 donne un exemple d'une telle barrette connue. Dans le cas particulier de la figure 1, les éléments photodétecteurs constituant la tête de lecture 4 de la barrette sont des photodiodes 2, alignées suivant l'axe XX, mais ce pourrait être aussi bien des photorésistances, des phototransistors et de manière générale tout élément délivrant un courant proportionnel à un rayonnement lumineux reçu. Ces éléments photodétecteurs sont rassemblés en p groupes de q éléments. Deux circuits $E_x$ et $E_y$ commandant des interrupteurs permettent d'adresser séparément chaque élément photodétecteur. Ces interrupteurs sont généralement réalisés au moyen de transistor MOS dont la grille est reliée aux circuits $E_x$ et $E_y$. Le circuit $E_x$ a p connexions, chacune permettant de sélectionner tous les éléments photodétecteurs d'un groupe particulier. Le circuit $E_y$ a q connexions, chacune permettant de sélectionner tous les éléments photodétecteurs occupant un rang particulier dans un groupe. Lorsqu'il est sélectionné simultanément par le circuit $E_x$ et par le circuit $E_y$, un élément photodétecteur est rendu actif, c'est-à-dire qu'il peut délivrer un signal fonction de l'éclairement reçu sur une des connexions $S_1, \ldots S_q$ du circuit de sortie S.

L'analyse de l'état de chacun des éléments photodétecteurs de la barrette se fait de la façon suivante. Dans l'état initial, les p connexions $X_1, X_2, \ldots X_p$ de $E_x$ et les q connexions $Y_1, Y_2, \ldots Y_q$ de $E_y$ sont dans un état électrique tel que tous les interrupteurs sont ouverts. On sélectionne alors le premier groupe de q éléments photodétecteurs en faisant apparaître sur la connexion $X_1$ du circuit $E_x$ un état électrique qui commande la fermeture de l'interrupteur $I_1$. On rend alors actif le premier élément photodétecteur du groupe en faisant apparaître sur la connexion $Y_1$ du circuit $E_y$ un état électrique qui commande la fermeture de l'interrupteur $I_{11}$. Il apparaît alors sur la connexion $S_1$ du circuit de sortie S un état électrique fonction de l'éclairement de l'élément photodétecteur activé. Ce signal est recueilli, puis ouvre l'interrupteur $I_{11}$. On procède alors de même pour chacun des éléments photodétecteurs du groupe. On ouvre ensuite l'interrupteur $I_1$, puis on procède pour chacun des groupes selon la même séquence d'opérations que pour le premier groupe.

Le principal inconvénient de ce système photodiode-interrupteurs MOS est l'extraction d'un signal à bas niveau sur les connexions $S_1, S_2, \ldots, S_q$ du circuit de sortie S. En effet, la fermeture des interrupteurs $I_{11}, I_{21}, \ldots, I_{p1}$ commandés par la connexion $Y_1$ du circuit $E_Y$ induit sur la connexion $S_1$ du circuit de sortie S un bruit de commutation non négligeable qui gêne l'exploitation de ce signal à bas niveau. De même, la fermeture des interrupteurs commandés respectivement par les connexions $Y_2, Y_3, \ldots, Y_q$ du circuit $E_y$ induit un bruit de commutation sur les connexions correspondantes $S_2, S_3, \ldots, S_q$ du circuit de sortie S.

On connaît également par le document EP—A—0 075 858, publié à une date postérieure à la date de priorité dont bénéficie la présente invention, et par le document Patents Abstracts of Japan, vol. 6, No. 6, 14 janvier 1982, page 884E89 présentant un résumé du document JP—A—56 129381, un dispositif de lecture point par point utilisant une matrice d'éléments photodétecteurs dans lequel chaque élément photodétecteur comporte une diode photosensible et une diode de blocage.

L'adressage des photodiodes est réalisé dans les dispositifs de chacun de ces deux documents par des circuits d'adressage comportant des interrupteurs.

Ces dispositifs présentent donc également un bruit de commutation non négligeable qui gêne l'exploitation des signaux délivrés par les photodiodes.

La présente invention a pour but d'atténuer ce bruit de commutation.

A cette fin, l'invention consiste à utiliser des éléments photodétecteurs comprenant chacun une photodiode et une diode insensible aux rayonnements lumineux, et à adresser ces éléments photodétecteurs par un circuit d'adressage constitué d'un registre à décalage.

De façon plus précise, l'invention a pour objet un dispositif de lecture d'un document point par point utilisant une matrice d'éléments photodétecteurs comprenant:

a) p groupes de q éléments de base 1 alignés suivant un axe XX et munis chacun d'une borne d'entrée et d'une borne de sortie, chaque élément de base étant constitué d'une photodiode 2 et d'une diode 3 insensible aux rayonnements lumineux, les électrodes de même polarité de la photodiode et de la diode étant reliées entre elles, les autres électrodes de la photodiode et de la diode constituant respectivement la sortie et l'entrée de l'élément de base,

b) un circuit d'entrée E pour sélectionner l'un quelconque des éléments de base,

c) un circuit de sortie S pour recevoir les signaux émis par les éléments de base sélectionnés, ledit dispositif étant caractérisé en ce que

d) le circuit d'entrée E est un registre à décalage et comporte p bornes de sorties $E_1, \ldots E_p$ sur lesquelles est appliqué séquentiellement un créneau de tension de polarisation,

e) la borne de sortie $E_i$ ($1 \leq i \leq p$) du circuit d'entrée E est reliée à la borne d'entrée de chaque élément de base du $i^{ème}$ groupe d'éléments de base,

f) le circuit de sortie S comporte q bornes d'entrée, la $j^{ème}$ ($1 \leq j \leq q$) borne d'entrée étant reliée à la borne de sortie de chaque élément de base de rang j dans chacune des q groupes d'éléments de base.

De façon préférée, la diode de chaque élément de base est une photodiode identique à la photodiode du même élément de base rendue insensible à tout rayonnement lumineux.

Cette construction privilégiée simplifie la réalisation de la barrette.

Par photodiodes identiques, on entend des photodiodes constituées des mêmes couches de semiconducteurs. Les électrodes de ces photodiodes peuvent cependant différer soit par leur nature, soit par leur épaisseur. Les photodiodes peuvent être de n'importe quel type et notamment de type Schottky, de type p.n., de type p.i.n. (p.intrinsèque.n), de type m.i.s. (métal-isolant-semiconducteur) ou autre. Les photodiodes sont réalisées au moyen d'un semiconducteur pris parmi les suivants: silicium amorphe hydrogéné, silicium polycristallin, arsénure de gallium (AsGa), sélénure de cadmium (CdSe).

Selon une caractéristique secondaire, chaque élément de base d'axe YY perpendiculaire à l'axe XX est constitue:

—d'un substrat isolant,

—de deux électrodes selon l'axe YY disposées symétriquement de part et d'autre de l'axe XX,

—d'une couche de semiconducteur dopé négativement recouvrant partiellement chaque électrode,

—d'une couche de semiconducteur intrinsèque recouvrant la couche précédente et l'espace interélectrodes,

—d'une électrode de type Schottky transparente aux rayonnements lumineux recouvrant la couche précédente et constituant la face d'entrée du photodétecteur,

—d'une résine opaque aux rayonnements lumineux recouvrant la partie de l'électrode précédente contenue dans un seul demi-plan défini par l'axe XX.

L'illumination de la photodiode se fait par l'électrode commune supérieure. Un autre mode de réalisation où l'illumination se fait par le substrat transparent est également possible. Les deux modes de réalisation sont envisageables avec tous les types de diodes et tous les semiconducteurs.

Selon une autre caractéristique secondaire, chaque élément de base, d'axe YY, est constitué:

—d'un substrat isolant, transparent aux rayonnements lumineux,

—d'une première electrode, de type Schottky, transparente aux rayonnements lumineux et située selon l'axe YY dans un demi-plan défini par l'axe XX, et constituant la face d'entrée du photodétecteur,

—d'une deuxième electrode de type Schottky, opaque aux rayonnements lumineux et située symétriquement à la première électrode par rapport à l'axe XX,

—d'une couche de semiconducteur intrinsèque disposée selon l'axe YY et recouvrant partiellement les première et deuxième électrodes,

—d'une couche de semiconducteur fortement dopé négativement recouvrant la couche précédente,

—d'une troisième électrode opaque aux rayonnements lumineux recouvrant la couche précédente.

L'invention a aussi pour objet un dispositif de lecture d'un document couleur point par point comprenant sur un même substrat plusieurs dispositifs de lecture conformes à l'invention alignés suivant un même axe XX et dans lequel les dispositifs de lecture sont identiques et tous les éléments de base d'un même dispositif sont recouverts par un même filtre absorbant une partie du spectre optique.

Sur un même substrat, on peut par exemple disposer trois dispositifs de lecture parallèles entre eux et décalés de quelques centaines de micromètres. Pour obtenir un dispositif de lecture couleur, on peut par exemple recouvrir chaque dispositif de lecture par un filtre coloré dont les couleurs sont complémentaires. Ces couleurs peuvent être rouge, vert et bleu. Un autre moyen d'obtenir un dispositif de lecture couleur est par exemple de choisir des photodiodes sensibles à une partie du spectre optique. Le temps de lecture de ce dispostif de lecture couleur est sensiblement identique au temps de lecture du dispositif à une tête de lecture puisque les trois têtes de lecture, indépendantes électriquement, fonctionnent simultanément.

De toute façon, les caractéristiques et avantages de l'invention apparaîtront mieux à la lecture de la description qui suit, d'exemples de réalisation donnés à titre explicatif et nullement limitatif. Cette description se réfère à des dessins annexés, sur lesquels:

—la figure 2a représente un élément de base du dispositif,

—la figure 2b représente la caractéristique courant-tension de l'élément de base de la figure 2a,

—la figure 3 représente une barrette d'éléments photodétecteurs,

—la figure 4 représente une réalisation de l'élément de base du dispositif,

—la figure 5 représente une autre réalisation de l'élément de base du dispositif.

La figure 2a représente un élément de base 1 selon l'invention formant un dipôle. Une photodiode 2 est montée en opposition avec une diode 3. L'électrode commune peut être soit la cathode (cas de la figure), soit l'anode. La tension V représente la différence de potentiel aux bornes du dipôle comptée de l'électrode de la diode 3 vers l'électrode de la photodiode 2. Le courant I

est compté positivement de la diode 3 vers la photodiode 2.

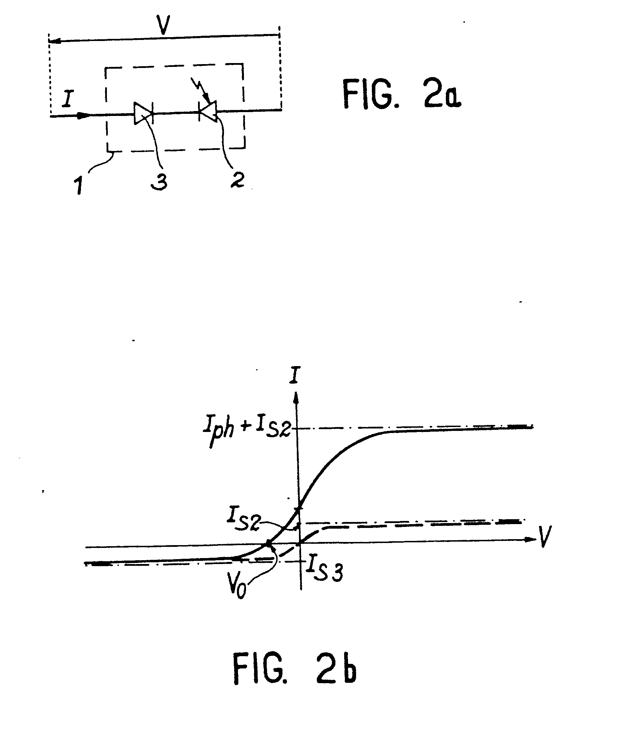

La figure 2b représente l'allure de la caractéristique courant-tension de ce dipôle. La photodiode 2 et la diode 3 possèdent chacune un courant de saturation ou courant inverse. Ce courant est très faible, de l'ordre de $10^{-12}$A. Il est représenté par la grandeur $I_{S2}$ pour la photodiode 2 et $I_{S3}$ pour la diode 3. La grandeur $I_{ph}$ représente le courant engendré par les photons éclairant la photodiode 2.

La courbe en traits tiretés représente la caractéristique de l'élément de base 1, lorsque la photodiode 2 n'est pas éclairée. Quelle que soit la tension aux bornes de l'élément de base 1, le courant circulant dans le système est compris entre $I_{S2}$ et $I_{S3}$. L'élément de base 1 est bloqué, il se comporte donc comme un interrupteur ouvert.

La courbe en trait plein représente la caractéristique de l'élément de base 1 lorsque la photodiode 2 est éclairée. Lorsque la tension de polarisation est inférieure à $V_0$, le courant circulant est compris entre $-I_{S3}$ et 0. L'élément de base 1 est alors bloqué. Lorsque la tension de polarisation est supérieur à $V_0$, il est conducteur. Le courant est alors proportionnel à la tension de polarisation jusqu'à une valeur asymptotique égale à $I_{S2}+I_{ph}$.

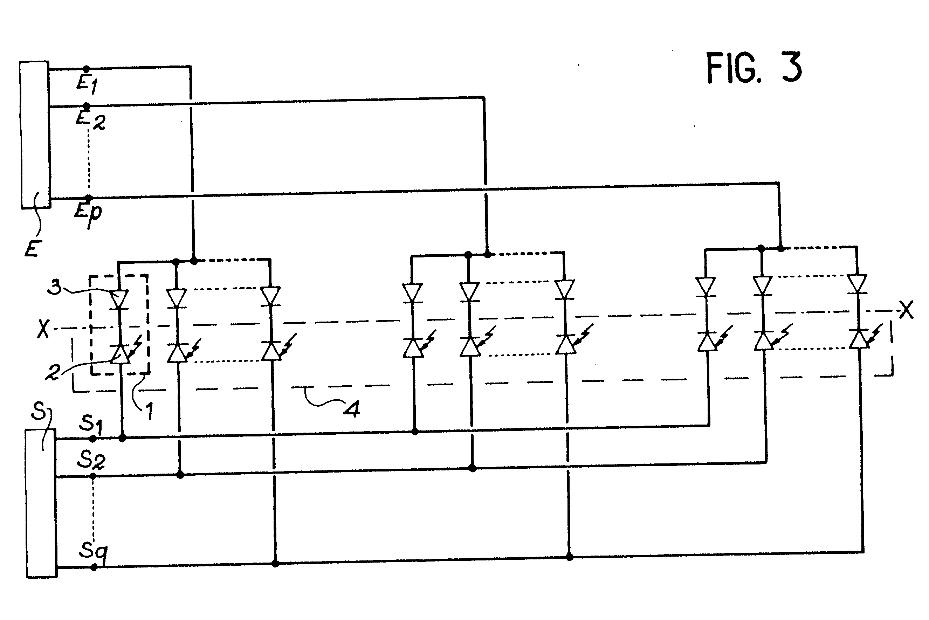

L'élément de base 1 est la partie essentielle du dispositif de lecture décrit par la figure 3. Les éléments de base 1 y sont arrangés en p groupes de q éléments alignés suivant l'axe XX. L'ensemble des photodiodes 2 constitue la tête de lecture 1. Le dispositif est complété par un circuit E de type registre à décalage dont chacune des p connexions est reliée à toutes les diodes non photosensibles d'un groupe d'éléments de base 1 et par un circuit S dont chacune des q connexions est reliée à toutes les photodiodes occupant un rang particulier dans un groupe. L'utilisation d'un registre à décalage élimine les interrupteurs utilisées habituellement dans le circuit d'entrée. Il en résulte dans signaux moins bruités.

L'analyse des éléments de base 1 se fait de la façon suivante. Le circuit E délivre sur la connexion $E_1$ une tension telle que les éléments du premier groupe sont actifs, c'est-à-dire que la caractéristique de ces élément est représentée par le trait plein de la figure 2b. Dans le cas des éléments de base de la figure 3, cela correspond à une tension supérieure à $V_0$. Sur les autres connexions $E_2$, $E_3$, . . ., $E_p$, le circuit E délivre une tension telle que les éléments de tous les groupes fonctionnent en interrupteur ouvert (traits tiretés de la figure 2b). Dans le cas des éléments de base de la figure 3, cela correspond à une tension inférieure à $V_0$. Ces éléments de base 1 sont alors bloqués.

Le circuit de sortie S comprend un ensemble de commutateurs, constitués par exemple de transistors CMOS, et un amplificateur opérationnel pour amplifier à un niveau exploitable les signaux délivrés par les éléments de base. L'état des commutateurs est tel que les connexions $S_1$, . . ., $S_q$ sont reliées en permanence à la masse.

Ceci limite considérablement le bruit et les courants parasites et améliore donc la qualité du signal délivré par l'amplificateur opérationnel.

Pour lire séquentiellement chaque élément de base 1 du premier groupe, il suffit de commander les commutateurs pour que successivement les connexions $S_1$, . . ., $S_q$ soient reliées à l'amplificateur opérationnel.

Une lecture en parallèle des éléments de base d'un même groupe est possible s'il est prévu dans le circuit S un amplificateur opérationnel pour chaque connexion de sortie $S_1$, . . ., $S_q$ au lieu d'un seul amplificateur opérationnel.

Lorsque tous les éléments de base du premier groupe ont été lus, le circuit E applique sur la connexion $E_1$ une tension telle que les éléments de base de ce groupe fonctionnent en interrupteur ouvert.

Les éléments de base des autres groupes sont successivement lus de la même manière que ceux du premier groupe. La sélection des différents groupes se fait en appliquant séquentiellement sur chaque connexion $E_1$, . . ., $E_p$ un créneau de tension de polarisation qui rend conducteurs les éléments de base reliés à ladite connexion.

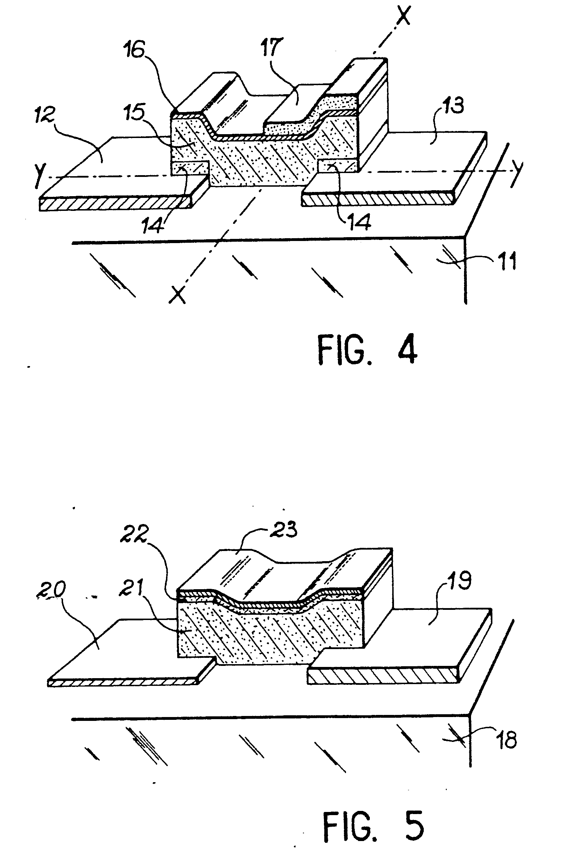

Un avantage de l'invention réside dans la diminution du bruit parasite sur les connexions $S_1$, $S_2$, . . ., $S_q$ du circuit de sortie S. Un autre avantage tient à la simplification de l'élément de base 1 de la barrette. La figure 4 montre un exemple de réalisation d'un élément de base 1 selon l'invention. Les éléments de base 1 sont disposés au pas de 100 µm le long d'un axe XX. Chaque élément de base 1 est constitué, sur un substrat isolant 11, de deux électrodes 12 et 13 gravées dans une couche de NiCr ou $In_2O_3$ d'épaisseur 3 000 Å. Ces électrodes 12 et 13 sont disposées selon un axe YY, l'axe XX passant entre les électrodes 12 et 13. Cette gravure, ainsi que les dépôts de couche suivants, est réalisée selon toute technique connue. Une couche 14 de silicium amorphe hydrogéné, fortement dopée avec des impuretés de type N, d'épaisseur 100 Å est déposée sur une partie de chaque électrode 12 et 13. Le rôle de cette couche 14 est d'assurer un meilleur contact ohmique. Cette couche 14 est recouverte par une couche 15 de silicium amorphe hydrogéné intrinsèque d'épaisseur comprise entre 5 000 et 10 000 Å. Sur cette couche 15, on dépose une couche 16 de métal Schottky, transparente aux rayonnements lumineux et suffisamment conductrice. Ce métal peut être par exemple du platine. Enfin, une couche 17 de résine opaque aux rayonnements lumineux est déposée selon l'axe YY dans un seul demi-plan défini par l'axe XX. On a alors deux diodes ayant une électrode commune, le métal Schottky, et chacune une électrode sur le substrat, la diode non recouverte de résine étant photosensible.

La figure 5 montre un autre mode de réalisation possible: les rayons lumineux arrivent sur la diode et la photodiode au travers d'un substrat isolant et transparent 18. On dépose une couche 20 de métal Schottky transparente aux rayonnements lumineux et suffisamment conductrice,

d'épaisseur 100 Å et une couche 19 de métal Schottky opaque aux rayonnements lumineux, d'épaisseur 1000 Å. Ce métal Schottky peut être par exemple du platine. Ces couches 19 et 20 sont recouvertes partiellement par une couche 21 de silicium amorphe hydrogéné intrinsèque d'épaisseur comprise entre 5000 et 10 000 Å. Cette couche 21 est recouverte par une couche 22 de silicium amorphe hydrogéné, fortement dopé avec des impuretés de type N, d'épaisseur 100 Å. Cette couche 22 est recouverte d'une électrode 23 en NiCr, d'épaisseur 3000 Å.

D'autres modes de réalisation possibles permettent d'utiliser des photodétecteurs à diodes p.i.n., p.n., m.i.s. On peut également utiliser tout autre semiconducteur déposé en couche mince: silicium polycristallin, AsGa, CdSe.

## Revendications

1. Dispositif de lecture d'un document point par point utilisant une matrice d'éléments photodétecteurs comprenant:

a) p groupes de q éléments de base (1) alignés suivant un axe XX et munis chacun d'une borne d'entrée et d'une borne de sortie, chaque élément de base étant constitué d'une photodiode (2) et d'une diode (3) insensible aux rayonnements lumineux, les électrodes de même polarité de la photodiode et de la diode étant reliées entre elles, les autres électrodes de la photodiode et de la diode constituant respectivement la sortie et l'entrée de l'élément de base,

b) un circuit d'entrée (E) pour sélectionner l'un quelconque des éléments de base,

c) un circuit de sortie (S) pour recevoir les signaux émis par les éléments de base sélectionnés, ledit dispositif étant caractérisé en ce que

d) le circuit d'entrée (E) est un registre à décalage et comporte p bornes de sorties $E_1, \ldots, E_p$ sur lesquelles est appliqué séquentiellement un créneau de tension de polarisation,

e) la borne de sortie $E_i$ ($1 \leqslant i \leqslant p$) du circuit d'entrée (E) est reliée à la borne d'entrée de chaque élément de base du $i^{ième}$ groupe d'éléments de base,

f) le circuit de sortie (S) comporte q bornes d'entrée, la $j^{ième}$ ($1 \leqslant j \leqslant q$) borne d'entrée étant reliée à la borne de sortie de chaque élément de base de rang j dans chacun des q groupes d'éléments de base.

2. Dispositif selon la revendication 1, caractérisé en ce que chaque élément de base (1) d'axe YY est constitué:

—d'un substrat isolant (11),

—de deux électrodes (12, 13) selon l'axe YY disposées symétriquement de part et d'autre de l'axe XX,

—d'une couche (14) de semiconducteur dopé négativement recouvrant partiellement chaque électrode (12 et 13),

—d'une couche (15) de semiconducteur intrinsèque receouvrant la couche précédente (14) et l'espace interélectrodes,

—d'une électrode (16) de type Schottky transparente aux rayonnements lumineux recouvrant la couche précédente (15) et constituant la face d'entrée du photo detécteur,

—d'une résine opaque (17) aux rayonnements lumineux recouvrant la partie de l'électrode (16) précédente contenue dans un seul demi-plan défini par l'axe XX.

3. Dispositif selon la revendication 1, caractérisé en ce que chaque élément de base (1), d'axe YY, est constitué:

—d'un substrat isolant (18), transparent aux rayonnements lumineux,

d'un première électrode (20) de type Schottky, transparente aux rayonnements lumineux et située selon l'axe YY dans un demi-plan défini par l'axe XX et constituant la face d'entrée du photodetécteur.

—d'une deuxième électrode (19) de type Schottky, opaque aux rayonnements lumineux et située symétriquement à la première électrode (20) par rapport à l'axe XX,

—d'une couche (21) de semiconducteur intrinsèque disposée selon l'axe YY et recouvrant partiellement des première et deuxième électrodes (19 et 20),

—d'une couche (22) de semiconducteur fortement dopé négativement recouvrant la couche précédente (21),

—d'une troisième électrode (23) opaque aux rayonnements lunineux recouvrant la couche précédente (22).

4. Dispositif de lecture d'un document couleur point par point comprenant sur un même substrat plusieurs dispositifs de lecture suivant l'une quelconque des revendications 1 à 3 alignés suivant un même axe XX, caractérisé en ce que ces dispositifs de lecture sont identiques et en ce que tous les éléments de base d'un même dispositif sont recouverts par un même filtre absorbant une partie du spectre optique.

## Patentansprüche

1. Vorrichtung zum punktweisen Lesen von Dokumenten unter Benutzung einer Matrix von Photodetektoren mit:

a) p Gruppen von q Grundelementen (1), die längs einer Achse XX angeordnet sind und von denen jedes mit einer Eingangsklemme und einer Ausgangsklemme versehen ist, wobei jedes Grundelement von einer Photodiode (2) und einer für Lichtstrahlen unempfindlichen Diode (3) gebildet ist, die Elektroden der gleichen Polarität der Photodiode und der Diode miteinander verbunden sind, die anderen Elektroden der Photodiode und der Diode jeweils den Ausgang und den Eingang des Grundelements bilden,

b) einem Eingangskreis (E), um irgendeines der Grundelemente auszuwählen,

c) einem Ausgangskreis (S), um die von den ausgewählten Grundelementen ausgesandten Signale zu empfangen, wobei die Vorrichtung dadurch gekennzeichnet ist, daß

d) der Eingangskreis (E) ein Schieberegister ist

und p Ausgangsklemmen E₁, ... Eₚ aufweist, an die sequentiell ein Polarisationsspannungsauftastimpuls angelegt wird,

e) die Ausgangsklemme Eᵢ (1≤i≤p) des Eingangskreises (E) mit der Eingangsklemme eines jeden Grundelements der i-ten Gruppe von Grundelementen verbunden ist,

f) der Ausgangskreis (S) q Eingangsklemmen aufweist, wobei die j-te (1≤j≤q) Eingangsklemme mit der Ausgangsklemme eines jeden Grundelements von Rang j in jeder der q Gruppen von Grundelementen verbunden ist.

2. Vorrichtung nach Anspruch 1, dadurch gekennzeichnet, daß jedes Grundelement (1) der Achse YY gebildet ist von:

—einem isolierenden Substrat (11),

—zwei Elektroden (12, 13) längs der Achse YY, die symmetrisch beidseitig der Achse XX angeordnet sind,

—einer Halbleiterschicht (14), die negativ dotiert ist und teilweise jede Elektrode (12 und 13) überdeckt,

—einer Eigenleitungs-Halbleiterschicht (15), die die vorhergehende Schicht (14) und den Zwischenelektrodenraum überdeckt,

—einer Elektrode (16) vom Schottky-Typ, die für Lichtstrahlung durchlässig ist, die vorgenannte Schicht (15) überdeckt und die Eingangsseite des Photodetektors bildet,

—einem für Lichtstrahlung undurchlässigen Kunstharz (17), welches den vorgenannten Teil der Elektrode (16) überdeckt, der in einer einzigen Halbebene enthalten ist, die durch die Achse XX festgelegt ist.

3. Vorrichtung nach Anspruch 1, dadurch gekennzeichnet, daß jedes Grundelement (1) der Achse YY gebildet ist von:

—einem isolierenden Substrat (18) welches für Lichtstrahlung durchlässig ist,

—einer ersten Elektrode (20) von Schottky-Typ, die für Lichtstrahlung durchlässig ist und sich längs der Achse YY in einer Halbebene befindet, die von der Achse XX festgelegt ist und die Eingangsseite des Photodetektors bildet,

—einer zweiten Elektrode (19) vom Schottky-Typ, die für Lichtstrahlung undurchlässig ist und sich symmetrisch zu der ersten Elektrode (20) im Bezug auf die Achse XX befindet,

—einer Eigenleitungs-Halbleiterschicht (21), die längs der Achse YY angeordnet ist und die erste und die zweite Elektrode (19 und 20) teilweise überdeckt,

—einer stark negativ dotierten Halbleiterschicht (22), die die vorgenannte Schicht (21) überdeckt,

—einer dritten, für Lichtstrahlung undurchlässigen Elektrode (23), die die vorgenannte Schicht (22) überdeckt.

4. Vorrichtung zum punktweisen Lesen von Farbdokumenten mit mehreren Lesevorrichtungen nach irgendeinem der Ansprüche 1 bis 3 auf dem gleichen Substrat, die längs der gleichen Achse XX ausgerichtet sind, dadurch gekennzeichnet, daß diese Lesevorrichtungen identisch sind und daß alle Grundelemente derselben Vorrichtung mit dem selben Filter überdeckt sind, der einen Teil des optischen Spektrums absorbiert.

## Claims

1. Apparatus for the point-by-point reading of a document using a matrix of photodetector elements comprising:

a) p groups of q basic elements (1) aligned in accordance with an axis XX and provided in each case with an input terminal and an output terminal, each basic element being constituted by a photodiode (2) and a diode (3) insensitive to light radiation, the electrodes of the same polarity of the photodiode and the diode being interconnected, the other electrodes of the photodiode and diode respectively constituting the output and input of the basic element,

b) an input circuit (E) for selecting any random one of the basic elements,

c) an output circuit (S) for receiving the signals emitted by the selected basic elements,

said apparatus being characterized in that

d) the input circuit (E) is a shift register and has p output terminals E₁ ... Eₚ to which is sequentially applied a polarization voltage square wave pulse,

e) the output terminal Eᵢ (1≤i≤p) of the input circuit (E) is connected to the input terminal of each basic element of the ith group of basic elements,

f) the output circuit (S) has q input terminals, the jth (1≤j≤q) input terminal being connected to the output terminal of each basic element of rank j in each of the q groups of basic elements.

2. Apparatus according to claim 1, characterized in that each basic element (1) of axis YY is constituted by:

an insulating substrate (11),

two electrodes (12, 13) along axis YY and arranged symmetrically on either side of axis XX,

a negatively doped semiconductor layer (14) partly covering each electrode (12, 13),

an intrinsic semiconductor layer (15) covering the previous layer (14) and the interelectrode space,

a Schottky electrode (16) transparent to the light radiation and covering the preceding layer (15) and constituting the input face of the photodetector,

a resin (17) opaque to light radiation covering that part of the preceding electrode (16) contained in a single half-plane defined by axis XX.

3. Apparatus according to claim 1, characterized in that each basic element (1) of axis YY is constituted by:

an insulating substrate (18) transparent to light radiation,

a first Schottky electrode (20), which is transparent to the light radiation and positioned along axis YY in a half-plane defined by axis XX and constituting the input face of the photodetector,

a second Schottky electrode (19), which is opaque to the light radiation and positioned symmetrically to the first electrode (20) with respect to axis XX,

an intrinsic semiconductor layer (21) positioned along axis YY and partly covering the first and second electrodes (19, 20),

a highly negatively doped semiconductor layer (22) covering the preceding layer (21),

a third electrode (23), which is opaque to light radiation and which covers the preceding layer (22).

4. Apparatus for the point-by-point reading of a colour document comprising on the same substrate several reading apparatuses according to any one of the claims 1 to 3, aligned in accordance with the same axis XX, characterized in that the reading apparatuses are identical and in that the basic elements of the same apparatus are covered by the same filter absorbing part of the optical spectrum.

FIG. 1

FIG. 2a

FIG. 2b

FIG. 3

FIG. 4

FIG. 5